Europäisches Patentamt

European Patent Office

Office européen des brevets

(11) Veröffentlichungsnummer: **0 215 156 B1**

# EUROPÄISCHE PATENTSCHRIFT

(45) Veröffentlichungstag der Patentschrift: **27.02.91**

(51) Int. Cl.⁵: **H03F 3/217**

(21) Anmeldenummer: **85116336.0**

(22) Anmeldetag: **20.12.85**

(54) **Netzgerät.**

(30) Priorität: 25.07.85 DE 3526548
01.10.85 DE 3534979

(43) Veröffentlichungstag der Anmeldung:
**25.03.87 Patentblatt 87/13**

(45) Bekanntmachung des Hinweises auf die
Patenterteilung:
**27.02.91 Patentblatt 91/09**

(84) Benannte Vertragsstaaten:
**CH DE FR GB LI**

(56) Entgegenhaltungen:
**EP-A- 0 066 904**
**EP-A- 0 124 765**
**DE-C- 1 284 986**
**US-A- 4 153 882**
**US-A- 4 403 197**

(73) Patentinhaber: **Licentia Patent-
Verwaltungs-GmbH
Theodor-Stern-Kai 1
D-6000 Frankfurt/Main 70(DE)**

(72) Erfinder: **Beeken, Horst
Teltower Strasse 14
D-1000 Berlin 20(DE)**
Erfinder: **Vitters, Hans-Heinrich
Hocksteinweg 2A
D-1000 Berlin 37(DE)**

(74) Vertreter: **Schulze, Harald Rudolf, Dipl.-Ing. et
al
Licentia Patent-Verwaltungs-GmbH Theodor-
Stern-Kai 1
D-6000 Frankfurt/Main 70(DE)**

## Beschreibung

Die Erfindung betrifft ein Netzgerät, insbesondere für die Erzeugung einer modulierten Anodenspannung für eine Endstufe eines Leistungssenders, nach dem Oberbegriff des Patentanspruchs 1.

Für einen beispielhaft gewählten Hochfrequenz-Hochleistungssender mit einer beispielhaften Ausgangsleistung von ungefähr 500kW und einer anodenmodulierten Hochfrequenzendstufenröhre ist es erforderlich, daß dieser eine mit einem Niederfrequenz (NF)-Signal amplitudenmodulierte Anodenspannung von ungefähr 30 kV zugeführt wird. Ein solcher Leistungssender sollte einen möglichst guten Wirkungsgrad besitzen.

Es sind Schaltverstärker bekannt, mit denen es möglich ist, mehrere schaltbare Gleichspannungssignale längs einer Diodenkaskade aufzusummieren, so daß die gewünschte Ausgangs-Hochspannung entsteht. Werden diese einzelnen Gleichspannungssignale in Abhängigkeit von einem NF-Signal geschaltet, so kann das Ausgangs-Hochspannungssignal als verstärktes NF-Signal betrachtet werden. Der Schaltverstärker enthält einen Netztransformator, der mindestens eine Primärwicklung enthält und eine Vielzahl von Sekundärwicklungen, die elektrisch nicht miteinander verbunden sind.

Dadurch ist es möglich, sekundärseitig sogenannte schwimmende Gleichspannungsquellen herzustellen, die im wesentlichen gleiche Ausgangsspannungen erzeugen und mit denen die erwähnte Summation erfolgt.

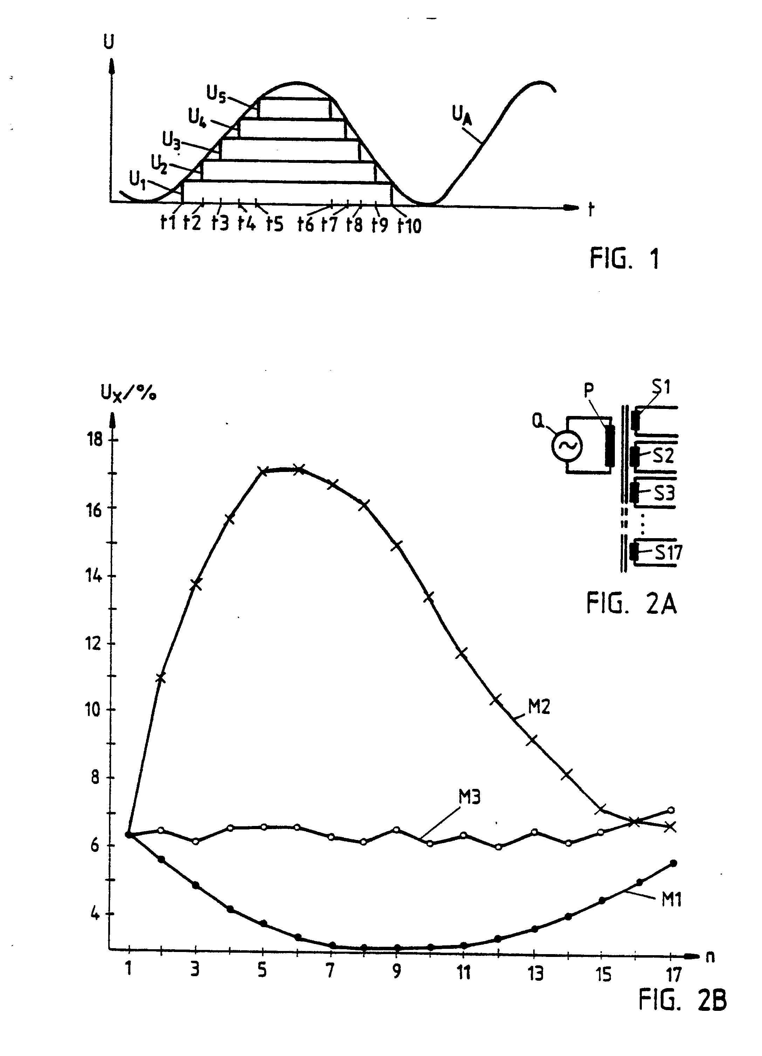

Eine solche Summation ist schematisch in Fig. 1 dargestellt, in der eine Gleichspannung U in Abhängigkeit von der Zeit t dargestellt ist. Die mit $U_A$ bezeichnete Kurve stelle eine zu erzeugende amplitudenmodulierte Anodenspannung dar. Diese wird angenähert durch die beispielhaft dargestellte Summation der im wesentlichen gleichen Einzel-Gleichspannungen $U_1$ bis $U_5$.

Aus der Figur ist ersichtlich, daß eine derartige Summation in nachteiliger Weise zu einer sehr ungleichmäßigen Belastungszeit der einzelnen Gleichspannungsquellen führt. Beispielsweise muß die zur Einzel-Gleichspannung $U_1$ ge hörende Gleichspannungsquelle zum Zeitpunkt $t_1$ eingeschaltet und zum Zeitpunkt $t_{10}$ ausgeschaltet werden während die zur Einzel-Gleichspannung $U_5$ gehörende Gleichspannungsquelle erst zu dem wesentlich späteren Zeitpunkt $t_5$ eingeschaltet wird und zu dem wesentlich früheren Zeitpunkt $t_6$ ausgeschaltet wird. In diesem Beispiel ist die zur Einzel-Gleichspannung $U_1$ gehörende Gleichspannungsquelle ungefähr zweimal so lange belastet wie die zur Einzel-Gleichspannung $U_5$ gehörende Gleichspannungsquelle.

Es ist nun naheliegend, die einzelnen Gleichspannungsquellen so aufzubauen, daß sie an die unterschiedlichen Belastungen angepaßt sind. Eine derartige Anpassung ist aber in nachteiliger Weise bei einer industriellen Serienfertigung sehr unwirtschaftlich.

Zur Vermeidung dieses Nachteils ist es weiterhin naheliegend, alle Gleichspannungsquellen für die größtmögliche Belastung aufzubauen. Ein solcher Aufbau ist ebenfalls lediglich in unwirtschaftlicher Weise herstellbar.

Es ist weiterhin erwünscht, den Wert der Einsel-Gleichspannungen möglichst klein zu wählen, um die in Fig. 1 dargestellte Stufenstruktur zu vermeiden. Dadurch ist die Erzeugung einer modulierten Anodenspannung möglich, die einen geringen Klirrfaktor besitzt.

Aus der Europäischen Patentschrift EP-A-0 124 765 ist ein Leistungsschaltverstärker zur Verstärkung eines modulierten Eingangssignals sowie ein Netzteil mit einer Mehrzahl von gleichen, zu- und abschaltbaren Spannungsstufen bekannt. Um eine gleichmäßige Belastung aller Spannungsquellen zu erzielen, ist die Reihenfolge des Wegschalters umgekehrt jener des Zuschaltens der Teilnetzgeräte. Anders als bei der vorliegenden Anmeldung werden die Betriebsparameter der einzelnen in Reihe geschalteten Netzgeräte überwacht und mit Hilfe einer Rückkopplungsschleife einem

Rechner oder einer Ansteuereinheit zuführt, die dann die Entscheidung trifft, welches Netzgerät wann und wie lange eingeschaltet wird. Der Zweck dieser Einrichtung ist es, die Belastung aller Netzgeräte möglichst gleich zu halten um eine Minimierung der Belastung dieser Bausteine zu erreichen.

Als nachteilig ist es zu betrachten, daß die Berechnung der Wahl der Einzelnetzgeräte nur auf die optimale Belastung und nicht auf die elektrische Geometrie des verwendeten Transformators Rücksicht nimmt. Weiterhin bedeutet es einen nicht unerheblichen Aufwand, bei jedem Netzgerät die Betriebsparameter zu messen und dann zu entscheiden, welches Teilnetzgerät geschaltet werden soll.

Der Erfindung liegt daher die Aufgabe zugrunde, ein gattungsgemäßen Netzgerät dahingehend zu verbessern, daß insbesondere die Erzeugung einer amplitudenmodulierten Anodenspannung mit einem geringen Klirrfaktor möglich ist für einen Hochfrequenz-Hochleistungssender, daß dabei die elektrischen Eigenschaften des Netztransformator sowie der Teilnetzgeräte derart berücksichtigt sind, daß insbesondere ein im wesentlichen konstanter Innenwiderstand vorhanden ist, und daß ein solches Netzgerät kostengünstig herstellbar ist, insbesondere bei einer industriellen Serienfertigung.

Diese Aufgabe wird gelöst durch die im Patentanspruch 1 angegebenen Merkmale. Vorteilhafte Ausgestaltungen und/oder Weiterbildungen sind den Unteransprüchen entnehmbar.

Der erste Vorteil ergibt sich daraus, daß während eines vorgebbaren Zeitintervalles immer alle Teilnetzgeräte nach einem fest vorgebbaren Schaltschema geschaltet werden, so daß der erforderliche Netztransformator im wesentlichen gleichmäßig belastet wird. Ein Rechner bzw. eine Überwachungseinheit mit einer Rückkopplungsschleife ist also nicht erforderlich. Dadurch wird erreicht, daß alle Teilnetzgeräte im wesentlichen den gleichen elektrischen Innenwiderstand besitzen. Dadurch wird erreicht, daß bei jedem Teilnetzgerät eine im wesentlichen unabhängige Ausgangsgleichspannung entsteht. Eine Summation mehrerer solcher Ausgangsgleichspannungen ermöglicht daher insbesondere das erwähnte modulierte Hochspannungssignal, das einen geringen Klirrfaktor besitzt.

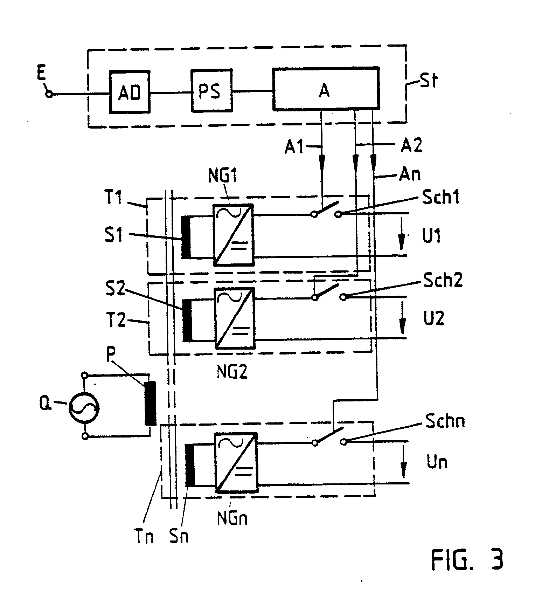

Die Erfindung wird im folgenden anhand eines Ausführungsbeispiels näher erläutert unter Bezugnahme auf die Figuren 2 und 3.

Die Erfindung beruht auf der überraschenden Erkenntnis, daß es bei einem Netztransformator mit einer Vielzahl von in Kammern gewickelten Sekundärwicklungen möglich ist, immer eine Gruppe der Sekundärwicklungen derart zu schalten, daß die elektrischen Eigenschaften des Netztransformators im wesentlichen konstant bleiben. Dadurch bleibt auch der Innenwiderstand der mit den Sekundärwicklungen hergestellten Teilnetzgeräte im wesentlichen konstant.

Dieses Verhalten eines Netztransformators wird im folgenden anhand der Fig. 2a und 2b erläutert. Fig. 2a zeigt einen beispielhaften Netztransformator mit einer Primärwicklung P sowie siebzehn in nebeneinanderliegenden Kammern gewickelten Sekundärwicklungen S1 bis S17, die von einem Ende beginnend fortlaufend numeriert sind. Die Primärwicklung ist an eine Wechselspannungsquelle Q angeschlossen. Wird bei einer derartigen Anordnung der Blindanteil bei sekundärseitigem Nennstrom von einer oder mehreren kurzgeschlossenen Sekundärwicklungen gemessen, so ergeben sich beispielsweise die Meßkurven gemäß Fig. 2b.

In Fig. 2b ist auf der Ordinate der Blindanteil $U_X$ in Prozent aufgetragen, bezogen auf die primärseitig gemessene effektive Wechselspannung. Der Realanteil $U_R$ ist bei großen Transformatoren vernachlässigbar. Bei der Meßkurve M1 ist jeweils lediglich eine einzige der Sekundärwicklungen S1 bis S17 kurzgeschlossen, deren Nummer durch die auf der Abszisse aufgetragene Zahl n bestimmt wird. Beim Kurzschluß der Sekundärwicklung S1 ist daher der Blindanteil $U_X$ beispielsweise ungefähr 3% größer als beim Kurzschluß der Sekundärwicklung S8.

Die Meßkurven M2 und M3 zeigen den prozentualen Blindanteil $U_X$ für den Fall, daß mehrere Sekundärwicklungen gleichzeitig kurzgeschlossen sind. Die auf der Abszisse aufgetragene Zahl n gibt dabei die Anzahl der kurzgeschlossenen Sekundärwicklungen an. Bei der Meßkurve M2 werden nun ausgehend von der Sekundärwicklung S1 (n = 1) nacheinander alle Sekundärwicklungen kurzgeschlossen und jeweils der prozentuale Blindanteil $U_X$ gemessen. Beispielsweise sind bei n = 7 die Sekundärwicklungen S1 bis S7 kurzgeschlossen und bei n = 17 die Sekundärwicklungen S1 bis S17. Bei dieser Meßkurve M2 ändert sich der Blindanteil $U_X$ sehr wesentlich von ungefähr 6% auf ungefähr 17%.

Bei der Meßkurve M3 gibt die Zahl n ebenfalls die Anzahl der kurzgeschlossenen Sekundärwicklungen an. Diese sind jedoch nach einem besonderen Plan kurzgeschlossen. Beispielsweise ist für n = 1 lediglich die Sekundärwicklung S1 kurzgeschlossen. Bei n = 4 sind beispielsweise die Sekundärwicklungen S1, S6, S8 und S9 kurzgeschlossen. Aus der Meßkurve M3 ist ersichtlich, daß durch diese Maßnahme die Schwankung des Prozentualen Blindanteils $U_X$ erheblich verringert wird.

Fig. 3 zeigt ein Ausführungsbeispiel eines Netzgerätes, mit dem eine stufenweise schaltbare Gleichspannung bis ungefähr 30kV bei ungefähr 40 A in Stufen von ungefähr 600 V möglich wird. Das schematisch dargestellte Netzgerät besteht aus einem Netztransformator mit einer Primärwicklung P, die beispielsweise für eine Netz-Wechselspannungsquelle von 380V und 50Hz ausgelegt ist. Dieser Netztransformator besitzt beispielsweise n Sekundärwicklungen S1 bis Sn, mit z.B. n = 50, die jeweils Bestandteil eines zugehörigen Teilnetzgerätes T1 bis Tn sind.

Jedes Teilnetzgerät T1 bis Tn enthält für die in den Sekundärwicklungen S1 bis Sn jeweils erzeugten Wechselspannungen eine beispielhafte Gleichrichtung NG1 bis NGn. Die erzeugten Gleichspannungen U1 bis Un, die jeweils ungefähr 600 V betragen und im wesentlichen gleich sind, werden geschaltet durch Schalter Sch1 bis Schn, die vorzugsweise als Halbleiter-Schalter ausgebildet sind. Diese Schalter werden angesteuert durch eine Schalteinheit St, die beispielsweise aus einem Analog-Digitalwandler AD, einer fest programmierbaren Steuereinheit (PS) sowie einer Ausgabeeimheit A besteht, deren Ausgänge A1 bis An mit den Schaltern Sch1 bis Schn verbunden sind und diese ansteuern. Der elektrische Eingang E der Schalteinheit ist mit einem Gleichspannungsgekoppelten Modulationssignal verbunden, z.B. einem NF-Signal mit einer Bandbreite von ungefähr 7,5 kHz. Diese Schalteinheit St ist so ausgebildet, daß immer eine dem Momentanwert der Amplitude des Modulationssignals entsprechende Anzahl von Teilnetzgeräten über die entsprechenden Schalter geschaltet wird unter Berücksichtigung eines gemessenen Schaltplanes einer der meßkurve M3 (Fig. 2b) entsprechenden Meßkurve. Dieser Schaltplan ist in die programmierbare Steuereinheit PS fest einprogrammiert, z.B. in einem programmierbarem Nurlesespeicher, der auch als PROM (" p rogrammable-r ead-o nly-m emory") bezeichnet wird. Dementsprechend wird bei einem geringen Momentanwert der Amplitude des Modulationssignals beispielsweise zunächst das Teilnetzgerät T1 eingeschaltet. Bei stetig zunehmendem Momentanwert werden dann beispielsweise nacheinander die Teilnetzgeräte T6, T27 sowie T48 eingeschaltet. Wächst der Momentanwert auf seinen Maximalwert, so sind beispielsweise insgesamt 48 Teilnetzgeräte eingeschaltet, wobei die Reihenfolge durch den gespeicherten Schaltplan festgelegt ist. Verringert sich nun der Momentanwert, so werden zunächst die zuerst eingeschalteten Teilnetzgeräte abgeschaltet, d.h. zuerst T1, dann T6, dann T27, dann T48 und so weiter.

Dieser Sachverhalt ist auch dadurch beschreibbar, daß die dem Momentanwert entsprechende Anzahl der Teilnetzgeräte zu einem Sektor zusammengefaßt werden, der innerhalb der ringförmig angeordneten Gesamtzahl (Schaltring) der Teilnetzgeräte rotiert mit einer Rotationsfrequenz, die wesentlich kleiner ist als die **Frequenz** des Modulationssignals. Durch diese Umschaltung wird vorteilhafterweise eine sehr gleichmäßige elektrische Belastung des Netztransformators erreicht. Dadurch ergibt sich ein im wesentlichen gleicher elektrischer Innenwiderstand aller Teilnetzgeräte, so daß durch deren Umschaltung kein zusätzlicher Klirrfaktor erzeugt wird bei einer beispielhaften anschließenden Summierung der Ausgangsspannungen der Teilnetzgeräte.

Insbesondere bei einem Hochfrequenzsender ist eine Betriebsart vorhanden, bei der kein Modulationssignal, z.B. ein NF-Signal, vorhanden ist. In einem solchen Fall soll jedoch am Ausgang des Netzgerätes eine bestimmte Spannung vorhanden sein, welche der Einstellung: Senden der unmodulierten Trägerfrequenz entspricht. Für diese Betriebsart ist es erforderlich, die beispielhaft erwähnte programmierbare Steuereinheit PS so zu programmieren, daß ledig lich immmer eine bestimmte Anzahl von Teilnetzgeräten eingeschaltet ist.

Diese Teilnetzgeräte sind zu einem Sektor zusammengefaßt, der innerhalb des Schaltringes umläuft (rotiert) mit einer fest einprogrammierten Frequenz von z.B. 200 Hz, so daß auch hier eine gleichmäßige Belastung der Teilnetzgeräte und des Netztransformators erreicht wird. Eine ähnliche Zwangsrotation wird erzeugt, wenn das Modulationssignal als Gleichspannungssignal ausgebildet ist. Bei Ausfall eines oder mehreren Teilnetzgeräten wird mit Hilfe der programmierbaren Steuereinheit der Schaltring entsprechend verkleinert, so daß wieder optimale Belastungsverhältnisse entstehen.

Die Erfindung ist nicht auf das beschriebene Ausführungsbeispiel beschränkt, sondern sinngemäß auf weitere anwendbar. Beispielsweise ist es möglich, den erwähnten einen einzigen Netztransformator durch mehrere zu ersetzen, deren einzelne Teilnetzgeräte dann in der beschriebenen Weise geschaltet werden. Weiterhin ist es beispielsweise möglich, die Schalteinheit St durch andere elektronische Logikbauelemente zu ersetzen, die derart verknüpft sind, daß die erwähnte Umschaltung ermöglicht wird.

Soll beispielsweise ein hochstabiles unmoduliertes Trägersignal ausgesandt werden. so ist es zweckmäßig, daß durch die Steuereinheit (PS) lediglich diejenigen Teilnetzgeräte eingeschaltet werden. die zum Erzeugen der erforderlichen Gleichspannung benötigt werden. Die Teilnetzgeräte werden dabei in der beschriebenen Weise durch die Steuereinheit so ausgewählt. daß eine optimale Belastung des Transformators erreicht wird. Unter normalen Betriebsbedingungen, das heißt. sofern kein Störfall vorliegt, wird keine Umschaltung der Teilnetzgeräte vorgenommen, um mögliche geringfügige Amplitudenschwankungen des Trägers zu vermeiden. welche durch den Umschaltvorgang entstehen.

## Ansprüche

1. Netzgerät, insbesondere für die Erzeugung einer modulierten Anodenspannung für eine Endstufe eines Leistungssenders, bestehend aus mindestens einem Netztransformator mit jeweils mindestens einer Primärwicklung, mehreren Sekundärwicklungen, die Bestandteil von Teilnetzgeräten (T1 bis Tn) sind zur Erzeugung unabhängig voneinander schalt- sowie addierbarer Gleichspannungen, die gesteuert werden durch eine Schalteinheit (St) an deren elektrischem Eingang (E) eine zu verstärkende Modulationsspannung anliegt und deren elektrische Ausgänge (A1 bis An) mit Schaltern (Sch1 bis Schn) der Teilnetzgeräte (T1 bis Tn) verbunden sind, die mit Hilfe der Schalter (Sch1 bis Schn) eine vom Momentanwert der Amplitude der Modulationsspannung abhängige Steuerung der Teilnetzgeräte (T1 bis Tn) bewirkt, wobei die Teilnetzgeräte (T1 bis Tn) zu deren gleichmäßiger Belastung so geschaltet werden, daß die Reihenfolge des Wegschaltens umgekehrt ist gegenüber der des Zuschaltens, dadurch gekennzeichnet, daß die Schalteinheit (St) eine fest programmierbare Steuereinheit (Ps) enthält, deren Schaltschema für die Teilnetzgeräte (T1 bis Tn) derart ausgewählt ist, daß die Summe der eingeschalteten Teilnetzgeräte (T1 bis Tn) im wesentlichen einen konstanten komplexen Innenwiderstand besitzt und auch bei konstanter Amplitude des zu verstärkenden Signals abwechselnd aus allen zur Verfügung stehenden Netzgeräten ausgewählt wird.

2. Netzgerät nach Anspruch 1, dadurch gekennzeichnet, daß die Steuereinheit (PS) derart eingestellt ist, daß die Teilnetzgeräte (T1 bis Tn) zyklisch umlaufend umgeschaltet werden innerhalb der ringförmig angeordneten Gesamtzahl der Teilnetzgeräte.

3. Netzgerät nach Anspruch 1 oder Anspruch 2, dadurch gekennzeichnet,
   - daß die Steuereinheit (PS) bei fehlender Modulationsspannung innerhalb der ringförmig angeordneten Gesamtzahl der Teilnetzgeräte eine dem Momentanwert entsprechende Anzahl bestimmter Teilnetzgeräte auswählt, in der soviele Teilnetzgeräte vorhanden sind, daß die Aussendung eines Hochfrequenz-Trägersignals gewährleistet ist, und
   - daß die Steuereinheit (PS) innerhalb der ringförmig angeordneten Gesamtzahl der Teilnetzgeräte von dieser dem Momentanwert entsprechenden Anzahl bestimmte Teilnetzgeräte auf andere dem Momentanwert entsprechende bestimmte Teilnetzgeräte periodisch umschaltet, derart, daß eine im wesentlichen gleichmäßige Belastung des Transformators sowie der Teilnetzgeräte (T1 bis Tn) erfolgt.

4. Netzgerät nach Anspruch 3, dadurch gekennzeichnet, daß die Steuereinheit (PS) zum Umschalten der dem Momentanwert entsprechenden bestimmten Teilnetzgeräte eine Schaltfrequenz erzeugt, die größer ist als die in einem Teilnetzgerät verwendete Siebkettenresonanzfrequenz.

5. Netzgerät nach einem der vorhergehenden Ansprüche, dadurch gekennzeichnet, daß in der ringförmig angeordneten Gesamtzahl der Teilnetzgeräte mindestens ein Teilnetzgerät mehr vorhanden ist als die für die Erzeugung der maximalen Spannung erforderliche Anzahl von Teilnetzgeräten, so daß bei voller Aussteuerung ein Umschalten der einzelnen dem vollen Maximalwert entsprechenden Anzahl von Teilnetzgeräten innerhalb der ringförmig angeordneten Gesamtzahl der Teilnetzgeräte möglich ist.

6. Netzgerät nach einem der vorhergehenden Ansprüche, dadurch gekennzeichnet, daß die Schalter (Sch1 bis Schn) als Halbleiterschalter ausgebildet sind.

7. Netzgerät nach einem der vorhergehenden Ansprüche, dadurch gekennzeichnet, daß in der programmierbaren Steuereinheit (PS) ein programmierbarer Nurlesespeicher enthalten ist, in welchem die Reihenfolge der zu schaltenden Teilnetzgeräte einprogrammiert ist entsprechend den gemessenen elektrischen Eigenschaften des Netztransformators.

8. Netzgerät nach einem der vorhergehenden Ansprüche, dadurch gekennzeichnet, daß die Steuereinheit (PS) derart ausgebildet ist, daß bei Ausfall eines oder mehrerer Teilnetzgeräte die restlichen betriebsfähigen Teilnetzgeräte zu einer verkleinerten ringförmig angeordneten Gesamtzahl der Teilnetzgeräte zusammengefaßt werden, die optimale Belastungsverhältnisse ermöglicht, und daß dadurch ein Weiterbetreiben ohne Betriebsunterbrechung möglich ist.

9. Netzgerät nach einem der vorhergehenden Ansprüche, dadurch gekennzeichnet, daß die Steuereinheit (PS) derart ausgebildet ist, daß bei einer als Gleichspannung ausgebildeten Modulationsspannung in der ringförmig angeordneten Gesamtzahl der Teilnetzgeräte die dem Momentanwert entsprechende Anzahl von Teilnetzgeräten erreicht wird durch fortlaufendes Zu- und Wegschalten bestimmter Teilnetzgeräte.

10. Netzgerät nach einem der vorhergehenden Ansprüche, dadurch gekennzeichnet, daß die Steuereinheit (PS) derart ausgebildet ist, daß zum Aussenden eines unmodulierten Trägersignals lediglich diejenigen Teilnetzgeräte eingeschaltet sind, die zum Erzeugen der erforderlichen Gleichspannung nötig sind, daß unter normalen Betriebsbedingungen ein Umschalten der Teilnetzgeräte vermieden wird und daß die Lage der Teilnetzgeräte derart ausgewählt ist, daß eine optimale Belastung des Transformators vorhanden ist.

## Claims

1. Mains unit, in particular for the production of a modulated anode voltage for an output stage of a high power transmitter and consisting of at least one mains transformer with at least one primary winding and several secondary windings which are component of partial mains units (T1 to Tn) for the production of direct voltages which are addable as well as switchable one independently of the other and are controlled by a switching unit (St), at the electrical input (E) of which a modulation voltage to be amplified is present and the electrical outputs (A1 to An) of which are connected with switches (Sch1 to Schn) of the partial mains units (T1 to Tn) and which with the aid of the switches (Sch1 to Schn) causes a control of the partial mains units (T1 to Tn) in dependence on the instantaneous value of the amplitude of the modulation voltage, wherein the partial mains units (T1 to Tn) are so switched for their uniform loading that the sequence of the switching-out is the reverse of that of the switching-in, characterised thereby, that the switching unit (St) contains a firmly programmable control unit (PS), the switching system of which for the partial mains units (T1 to Tn) is chosen in such a manner that the sum of the partial mains units (T1 to Tn), which are switched in; possesses substantially a constant complex internal impedance and is chosen in turns from all mains units standing at disposal even for constant amplitude of the signal to be amplified.

2. Mains unit according to claim 1, characterised thereby, that the control unit (PS) is set in such a manner that the partial mains units (T1 to Tn) are switched over in cyclic rotation within the total number of the partial mains units arranged in the shape of a ring.

3. Mains unit according to claim 2, characterised thereby,
   - that the control unit (PS) in the case of absent modulation selects, within the total number of the partial mains units arranged in the shape of a ring, a number of certain partial mains units, which corresponds to the instantaneous value and in which so many partial mains units are present that the emission of a high-frequency carrier signal is assured and
   - that the control unit (PS) periodically switches, with in the total number of the partial mains units arranged in the shape of a ring, from this number, which corresponds to the instantaneous value, of certain partial mains units to other certain partial mains units corresponding to the instantaneous value in such a manner that a substantially uniform loading of the transformer of the partial mains units (T1 to Tn) takes place.

4. Mains unit according to claim 3, characterised thereby, that the control unit (PS) produces a switching frequency, which is greater than the resonant frequency of the filter chain used in a partial mains unit, for the switching-over of the certain partial mains units corresponding to the instantaneous value.

5. Mains unit according to one of the preceding claims, characterised thereby, that within the total number of the partial mains units arranged in the shape of a ring, at least one more partial mains unit is present than the number required for the production of the maximum voltage so that, when driven to full output, a switching-over of the individual partial mains units, which correspond in number to the full maximum value is possible within the total number of the partial mains units arranged in the shape of a ring.

6. Mains unit according to one of the preceding claims, characterised thereby, that the switches (Sch1 to Schn) are constructed as semiconductor switches.

7. Mains unit according to one of the preceding claims, characterised thereby, that a programmable read-only memory, in which the sequence of the partial mains units to be switched is programmed in accordance with the measured electrical properties of the mains transformer, is contained in the programmable control unit (PS).

8. Mains unit according to one of the preceding claims, characterised thereby, that the control unit (PS) is constructed in such a manner that, on the failure of one or more partial mains units, the remaining operationally capable partial mains units are combined into a reduced total number of the partial mains units arranged in the shape of a ring, which number makes the optimum loading conditions possible, and that a continued operation without interruption of operation is possible thereby.

9. Mains unit according to one of the preceding claims, characterised thereby, that the control unit (PS) is constructed in such a manner that, in the case of a modulation voltage formed as direct voltage, the number of partial mains units, which corresponds to the instantaneous value, is achieved within the total number of the partial mains units arranged in the shape of a ring by continuous switching in and out of certain partial mains units.

10. Mains unit according to one of the preceding claims, characterised thereby, that the control unit (PS) is constructed in such a manner that, for the transmission of an unmodulated carrier signal, merely those partial mains units are switched in, which are necessary for the production of the necessary direct voltage, that a switching-over of the partial mains units is avoided under normal operating conditions and that the position of the partial mains units is chosen in such a manner that an optimum loading of the transformer is present.

## Revendications

1. Alimentation électrique, en particulier destinée à produire une tension d'anode modulée pour un étage final d'un émetteur de puissance, composée d'au moins un transformateur de réseau avec chacun au moins un bobinage primaire, plusieurs bobinages secondaires qui sont intégrés à des alimentations électriques élémentaires (T1 à Tn) pour produire des tensions continues commutables et additionnables indépendamment les unes des autres, qui sont commandées par une unité de commutation (St) qui reçoit à son entrée électrique (E) une tension de modulation à amplifier et qui est reliée par ses sorties électriques (A1 à An) à des commutateurs (Sch1 à Schn) des alimentations électriques élémentaires (T1 à Tn), qui, à l'aide des commutateurs (Sch1 à Schn), opère une commande des alimentations électriques élémentaires (T1 à Tn) en fonction de l'amplitude instantanée de la tension de modulation, ces alimentations électriques élémentaires (T1 à Tn) étant commutées dans un ordre de mise hors service inverse de l'ordre de mise en service de manière à assurer une sollicitation régulière, caractérisé en ce que l'unité de commutation (St) possède une unité de commande programmable (PS) dont le schéma de commutation des alimentations électriques élémentaires (T1 à Tn) est choisi de manière à ce que la somme des alimentations électriques élémentaires (T1 à Tn) en service possède essentiellement une résistance interne complexe constante et, en cas d'amplitude constante du signal à amplifier, est choisie alternativement parmi toutes les alimentations électriques disponibles.

2. Alimentation électrique selon la revendication 1, caractérisée en ce que l'unité de commande (PS) est réglée de manière à ce que les alimentations électriques élémentaires (T1 à Tn) soient commutées de manière cyclique au sein du total des alimentations électriques élémentaires organisées en forme d'anneau.

3. Alimentation électrique selon la revendication 1 ou 2, caractérisée en ce que l'unité de commande (PS), en l'absence de tension de modulation, sélectionne sur le total des alimentations électriques élémentaires organisées en anneau un nombre correspondant à la valeur instantanée de certaines alimentations électriques élémentaires et comprenant suffisamment d'alimentations électriques élémentaires pour assurer l'émission d'un signal de porteuse à haute fréquence, et en ce que l'unité de commande (PS), au sein du total des alimentations électriques élémentaires organisées en anneau, commute périodiquement de ce nombre correspondant à la valeur instantanée de certaines des alimentations électriques élémentaires à d'autres alimentations électriques élémentaires déterminées correspondant à la valeur instantanée, de manière à assurer une sollicitation essentiellement régulière du transformateur ainsi que des alimentations électriques élémentaires (T1 à Tn).

4. Alimentation électrique selon la revendication 3, caractérisée en ce que l'unité de commande (PS) génère pour commuter les alimentations électriques élémentaires déterminées correspondant à la valeur instantanée une fréquence de commutation qui est plus grande que la fréquence de résonance de la chaîne de filtrage de l'alimentation électrique élémentaire.

5. Alimentation électrique selon une des revendications précédentes, caractérisée en ce que, sur le total des alimentations électriques élémentaires organisées en anneau, il existe au moins une alimentation électrique élémentaire de plus que le nombre d'alimentations électriques élémentaires nécessaire pour générer la tension maximale, si bien que, à l'excursion maximale, il est possible de commuter au sein du total des alimentations électriques élémentaires organisées en anneau les différentes alimentations électriques élémentaires dont le nombre correspond à la valeur maximale.

6. Alimentation électrique selon une des revendications précédentes, caractérisée en ce que les commutateurs (Sch1 à Schn) sont des commutateurs à semiconducteurs.

7. Alimentation électrique selon une des revendications précédentes, caractérisée en ce que l'unité de commande programmable (PS) possède une mémoire à lecture seulement dans laquelle est programme l'ordre des alimentations électriques élémentaires à commuter en fonction des propriétés électriques mesurées du transformateur de réseau.

8. Alimentation électrique selon une des revendications précédentes, caractérisée en ce que l'unité de commande (PS) est faite de manière à ce que, en cas de panne d'une ou plusieurs des alimentations électriques élémentaires, le reste des alimentations électriques élémentaires en état de fonctionnement est réuni en un total des alimentations électriques élémentaires organisé en anneau de taille réduite, permettant des conditions de fonctionnement optimales, et en ce qu'il est ainsi possible de poursuivre le fonctionnement sans interruption.

9. Alimentation électrique selon une des revendications précédentes, caractérisée en ce que l'unité de commande (PS) est faite de manière à ce que, lorsque la tension de modulation est une tension continue, le nombre des alimentations électriques élémentaires correspondant à la valeur instantanée sur le total des alimentations électriques élémentaires organisées en anneau est obtenu par la commutation régulière de certaines alimentations électriques élémentaires.

10. Alimentation électrique selon une des revendications précédentes, caractérisée en ce que l'unité de commande (PS) est faite de manière à ce que, pour émetteur un signal de porteuse non modulé, seules sont commutées les alimentations électriques élémentaires qui sont nécessaire pour générer la tension continue nécessaire, en ce que, dans des conditions de fonctionnement normales, on évite de commuter les alimentations électriques élémentaires et en ce que la position des alimentations électriques élémentaires est choisie de manière à assurer une charge optimale du transformateur.

FIG. 1

FIG. 2A

FIG. 2B

FIG. 3